# EUROPEAN PATENT SPECIFICATION

(11) **EP 2 629 320 B1**
(45) Date of publication and mention of the grant of the patent: **17.10.2018**
(21) Application number: 13155361.2
(22) Date of filing: 15.02.2013
(51) Int. Cl.: H01L 21/20, H01L 21/02, H01L 23/04, H01L 25/04, H01L 29/66, C30B 19/00, C30B 23/04, C30B 25/04, C30B 29/40

(54) **Mask structure and method for defect-free heteroepitaxial deposition**
Maskenstruktur und Verfahren für defektfreie heteroepitaktische Abscheidung
Structure de masque et procédé de dépôt hétéroépitaxial sans défaut

(30) Priority: 15.02.2012 US 201261599120 P
(43) Date of publication of application: 21.08.2013
(73) Proprietor: IMEC VZW, 3001 Leuven (BE)
(72) Inventor: Vincent, Benjamin, 3001 Leuven (BE); Thean, Aaron, 3001 Leuven (BE); Witters, Liesbeth, 3001 Leuven (BE)
(74) Representative: DenK iP

(56) References cited:
- EP-A2- 0 951 055
- EP-A2- 2 343 742
- HIRAMATSU K: "Epitaxial lateral overgrowth techniques used in group III nitride epitaxy", JOURNAL OF PHYSICS: CONDENSED MATTER, INSTITUTE OF PHYSICS PUBLISHING, BRISTOL, GB, vol. 13, no. 32, 13 August 2001 (2001-08-13), pages 6961-6975, XP009141205, ISSN: 0953-8984, DOI: 10.1088/0953-8984/13/32/306

## Description

### Field of the Invention

The present invention is related to methods and mask designs for hetero-epitaxial growth of semiconductor material that is defect-free.

### State of the art.

Heteroepitaxial growth of semiconductors usually suffers from strain relaxation dislocations formation due to the difference (mismatch) of lattice parameters. One solution proposed in the literature is the selective growth of semiconductor in narrow oxide trenches. This technique called Aspect Ratio Trapping (ART) permits to trap all the defects at the bottom of the trenches using the oxide trenches sidewalls. The top part of the semiconductor grown in the trench should then be relaxed without defects. An example wherein the ART technique is applied is described in patent application US20100216277. EP 2 343 742 A2 discloses the reduction of defects in heteroepitaxy using lateral epitaxial overgrowth with so called aspect ratio trapping method. The depth of the trenches is chosen so that dislocations lying in inclined planes are stopped at the trench sidewalls and do not propagate into the top part of the laterally overgrown film.

EP 0 951 055 A2 discloses Lateral epitaxial overgrowth by the so-called pendeo-epitaxy method. An embodiment with subsequent masking steps with two levels of orthogonal trenches is disclosed. The purpose of the top level trenches is to halt defects extending in the length direction of the bottom level trenches.

The state of the art ART technique works only for narrow and short trenches, since only in these trenches it can form defect free relaxed semiconductors. However, for various applications such as advanced logic CMOS devices and photonics, long trenches are required.

### Summary of the invention

The invention is related to a mask structure suitable for producing a defect free epitaxially grown structure of a crystalline material on substrate of another crystalline material, the two materials having difference lattice constants. The mask comprises two levels : a first level comprising a first layer provided with a first opening, for example of first trench, the bottom of which is formed by the substrate formed of the first material. The second level comprises at least a barrier placed on at least two opposite sides of the trench. According to a preferred embodiment, the second level comprises one or more second trenches arranged perpendicularly to the first trench. The depth and width of the first and second trenches is such that defects generated in the epitaxially grown layer of the second material at the substrate portion at the bottom of the first trench, and propagating in the direction of the second trenches are trapped in the first trench. In this way, in the larger portion of the second trenches, essentially defect free material can be grown.

The present invention relates to a mask structure configured to trap the strain relaxation dislocations (hereafter referred to as 'defects') in all directions in a semiconductor material grown epitaxially therein. More particularly the mask structure is configured to trap the strain relaxation dislocations along the long trenches.

Further the present disclosure also relates to a method for heteroepitaxial growth of semiconductor materials in a mask structure which is configured to trap the strain relaxation dislocations in all directions and particularly along the long trenches.

The invention is related to methods and products as disclosed in the appended claims.

The invention is thus related to a method for producing an essentially defect-free epitaxially grown structure, comprising the steps of :
- Providing a substrate formed of a first crystalline material,
- Placing or producing a mask structure on the surface of said substrate, the mask structure comprising:
   ∘ A first level comprising a first dielectric layer provided with at least one opening through the complete thickness of said layer, so that the bottom of said opening is formed by a portion of the surface of said substrate,
   ∘ A second level on top of the first, the second level comprising one or more barriers placed at least on two opposite sides of each of said at least one opening or of a group of said openings,
- Growing a second crystalline material by epitaxial growth on said surface portion, the second material having a lattice constant that is different from the lattice constant of the first material, said second material overgrowing said opening and forming a layer of the second material, wherein the depth and shape of said opening is such that lattice defects propagating from said surface portion in at least one direction are trapped in said opening, by having a depth of the opening being equal to or higher than three times its width,
- Stopping said growing step when at least a part of the height of said barrier is covered by the layer of the second material,
- planarizing the layer of the second material.

According to the present invention
- said opening is a first trench provided in the first dielectric layer OR the first dielectric layer comprises a row of said openings,
- the second level further comprises a second dielectric layer on the first dielectric layer provided with at least one second trench oriented at an angle different from zero with respect to the first trench or with respect to said row of openings, at least a portion of the second trench or trenches being located laterally with respect to the longitudinal direction of said first trench or row of openings. In other words, at least a portion of the second trenches is located lateral to one and/or the other side of the first trench or the row of openings, overlying the first dielectric layer. In this way, material overgrowing the first trench is able to grow over the first dielectric layer into the second trenches.
- any defects propagating in the longitudinal direction of said second trench(es) are trapped in said first trench or in said row of openings,
- the depth and width of the second trench or trenches is such that essentially defect-free material grows in at least a portion of the second trench or trenches, by having a depth of said second trench(es) being equal to or higher than three times its width,
- said barriers are located at least on two opposite sides of the longitudinal direction of said first trench or of said row of openings.

In the latter embodiment, the second level may comprise one or more arrays of mutually parallel trenches, each array being located laterally with respect to the longitudinal direction of said first trench or row of openings. Said second trench may be oriented perpendicularly to the first trench or the row of openings.

The method of the invention may further comprise the step of removing at least the epitaxially grown material in said first trench or row of openings and directly above said first trench or openings, so that only said second trench or trenches remain or at least portions of said second trench(es) remain which consist of essentially defect-free material.

According to an embodiment, said opening has a depth and shape so that essentially all defects propagating from said surface portion are trapped in said opening, and the second level consists only of said barriers, which are located so as to surround each of said openings on all sides.

The first and second materials used in the method of the invention may be semiconductor materials.

The invention is equally related to a mask structure for epitaxially growing a second crystalline material on a surface portion of a substrate formed of a first crystalline material, said materials having different lattice constants, when the mask structure is present on said substrate, said mask structure comprising
- A first level comprising a first dielectric layer provided with at least one opening through the complete thickness of said layer, so that the bottom of said opening is formed by a portion of the surface of said substrate,
- A second level on top of the first, the second level comprising one or more barriers placed at least on two opposite sides of each of said openings or of a group of said openings.

According to the present
invention,
- said opening is a first trench provided in the first dielectric layer OR the first dielectric layer comprises a row of said openings,
   said opening(s) having a depth of the first opening being equal to or higher than three times its width;
- the second level further comprises a second dielectric layer provided with at least one second trench oriented at an angle different from zero with respect to the first trench or with respect to said row of openings, at least a portion of the second trench or trenches being located laterally with respect to the longitudinal direction of said first trench or row of openings, wherein the depth of the second trench is equal to or higher than three times its width
- said barriers are located at least on two opposite sides of the longitudinal direction of said first trench or of said row of openings.

In the latter embodiment of said mask structure, the second level may comprise one or more arrays of mutually parallel trenches, each array being located laterally with respect to the longitudinal direction of said first trench or row of openings. The second trench may be oriented perpendicularly to the first trench or the row of openings.

Also disclosed but not part of the invention is a method for producing an essentially defect-free epitaxially grown structure, comprising the steps of :
- Providing a substrate formed of a first crystalline material,
- Placing or producing a mask structure on the surface of said substrate, the mask structure comprising:
   ∘ A first level comprising a first dielectric layer provided with a trench or a row of openings, said trench or openings being made through the complete thickness of said layer, so that the bottom of said trench or openings is formed by a portion of the surface of said substrate,
   ∘ A second level comprising a second dielectric layer on top of the first dielectric layer, said second layer being provided with one or more trenches oriented at an angle different from zero with respect to said first trench or with respect to said row of openings, at least a portion of the second trench or trenches being located laterally with respect to the longitudinal direction of said first trench or row of openings,
      - Growing a second crystalline material by epitaxial growth on said surface portion, the second material having a lattice constant that is different from the lattice constant of the first material, said second material overgrowing said first trench and forming a layer of the second material on top of said first dielectric layer, wherein :
   ∘ the depth and width of said first trench or the depth and cross-section of the openings in said row of openings is such that lattice defects propagating in the longitudinal direction of said second trench are trapped in said first trench or in said openings,
   ∘ the depth and width of the second trench or trenches is such that essentially defect-free material grows in at least a portion of the second trench or trenches.
      - Stopping said growing step when said layer overfills all of the second trenches,
      - planarizing the layer of the second material.

Also disclosed but not part of the invention is a mask structure for epitaxially growing a second crystalline material on a surface portion of a substrate formed of a first crystalline material, said materials having different lattice constants, when the mask structure is present on said substrate, said mask structure comprising
- A first level comprising a first dielectric layer provided with a trench or a row of openings, said trench or openings being made through the complete thickness of said layer, so that the bottom of said trench or openings is formed by a portion of the surface of said substrate,
- A second level comprising a second dielectric layer on top of the first dielectric layer, said second layer being provided with one or more trenches oriented at an angle different from zero with respect to said first trench or with respect to said row of openings, at least a portion of the second trench or
   trenches being located laterally with respect to the longitudinal direction of said first trench or row of openings.

In a specific embodiment of the mask structure according to the previous paragraph, the depth of the first trench is equal to or higher than three times its width, and the depth of the second trench is equal to or higher than three times its width.

### Brief description of the figures

All drawings are intended to illustrate some aspects and embodiments of the present disclosure. The drawings described are only schematic and are nonlimiting.
Figure 1a shows a cross section Transmission Electron Microscopy (XTEM) picture perpendicular to the trench showing defect trapping at the bottom of the trench in a technique according to the prior art. Figure 1b shows XTEM pictures along the trench showing that defects still remain in the top part of the trench because of the absence of defect trapping in this direction.
Figure 2 shows schematically a mask structure according to the invention.

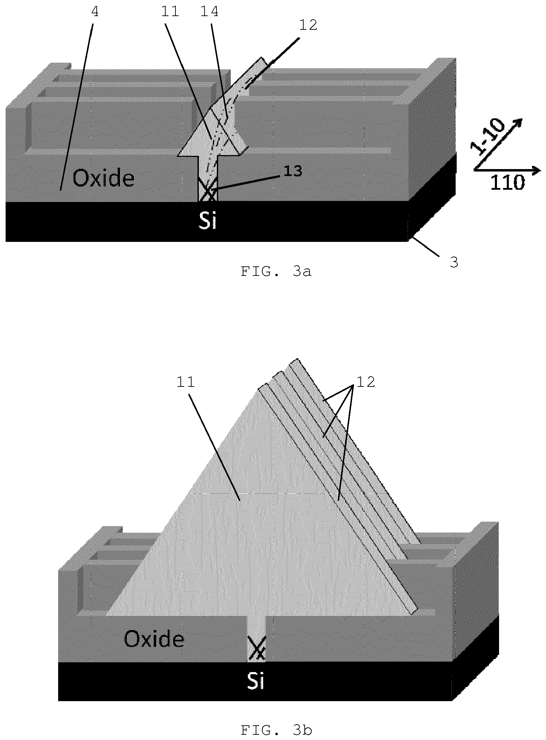

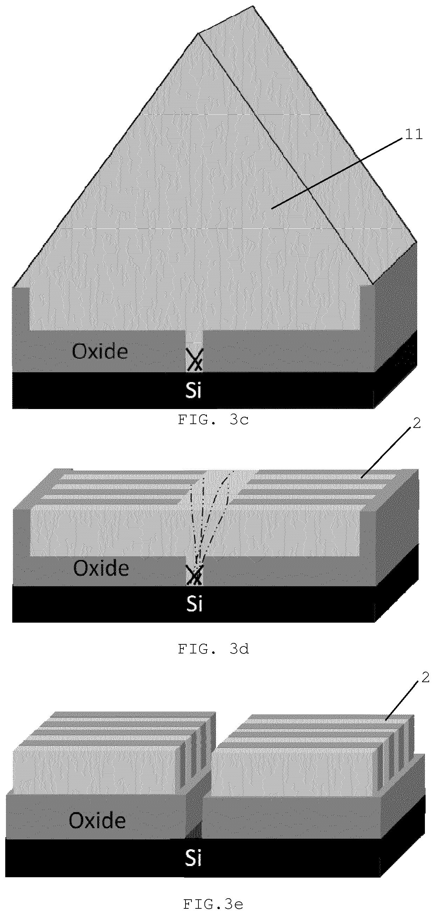

Figures 3a to 3e illustrate the method according to the invention. Fig. 3a illustrates the first step : overgrowth of the first trench; defects perpendicular (full lines) to the trench are trapped, defects along the trench (dotted lines) are not. Fig. 3b illustrates the lateral trench filling from the 111 facets growth. Fig. 3c shows the complete overgrowth of the double trenches (first and second trenches) array structures by 111 facets growth. Fig. 3d shows the overall structure after a chemical mechanical polishing (CMP) step. Fig. 3e shows the structure obtained after etching of the defective areas.
Figures 4a to 4d illustrate a fabrication method for a mask structure according to the invention comprising the steps of: (4a) poly deposition on Si STI wafers; (4b) patterning the sacrificial poly layer such that the poly lines formed have a width corresponding to the required width of the second trenches wherein the semiconductor material is grown in a subsequent step; (4c) oxide filling of the trenches formed in the poly material followed by CMP; (4d) poly removal thereby forming the second trenches separated by oxide.
Figures 5a to 5c illustrate another fabrication method for the same mask structure: (5a) Si STI wafers after STI-oxide CMP; (5b) STI-oxide patterning selective to nitride hardmask; (5c) nitride hardmask and/or underlying padoxide layer removal.
Fig 6 shows a mask structure according to an embodiment of the invention having continuous lines (un-interrupted lines) and trenches formed on top of the STI oxide instead of 2 separate arrays of trenches as in Fig 2.
Fig 7 shows a mask structure according to another embodiment of the invention having the single narrow trench (the first trench) replaced by holes/vias so that the initial growth of the semiconductor material takes place in holes/vias instead of single narrow trench.
Figure 8a shows an embodiment not part of the invention wherein the mask comprises two levels, the first one comprising a plurality of openings, the second one comprising barriers placed around each opening. Figure 8b illustrates the method according to the invention, using a mask structure as shown in Fig. 8a.

### Detailed description of embodiments according to the invention

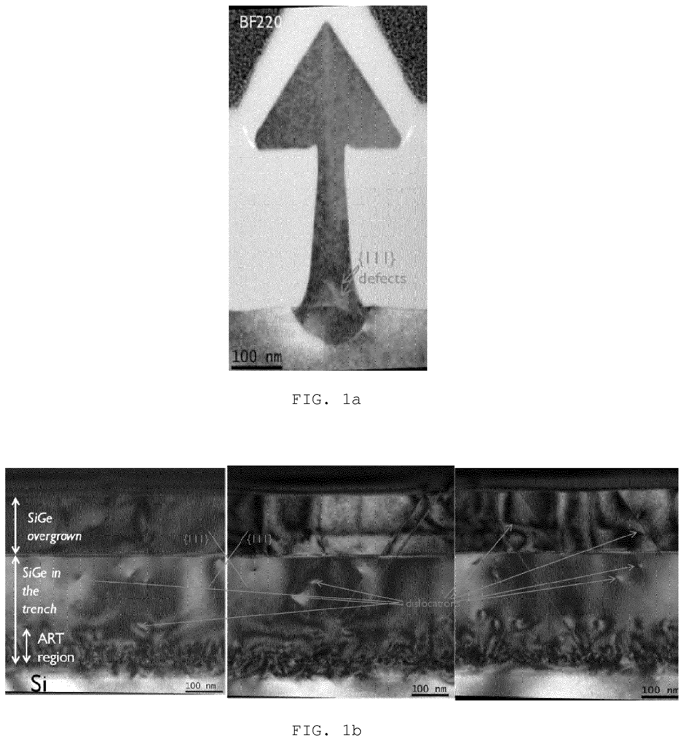

Figure 1a illustrates the known ART approach referred to above, for relaxed SiGe grown in 30nm trenches: all 111 defects coming from the SiGe/Si interface are trapped and the top SiGe layer is defect free. This technique solves actually only partially the dislocation formation issue since no ART can be obtained along the trenches. In Figure 1b, a cross section TEM (XTEM) performed along the trench reveals a large number of dislocations even in the top part of the trench which have not been trapped.

The state of the art ART technique works then only for narrow and short trenches, since only in these trenches it can form defect free relaxed semiconductors. However, for various applications such as advanced logic CMOS devices and photonics long trenches are required. For example, minimum length of the trench for 1 transistor is around 100nm for the 14nm technology node. However, having 1 longer trench allows for connecting subsequent transistors through the trench rather than going through local interconnect wiring, which increases packing density of transistors. Therefore trenches up to few microns are desirable for advanced devices.

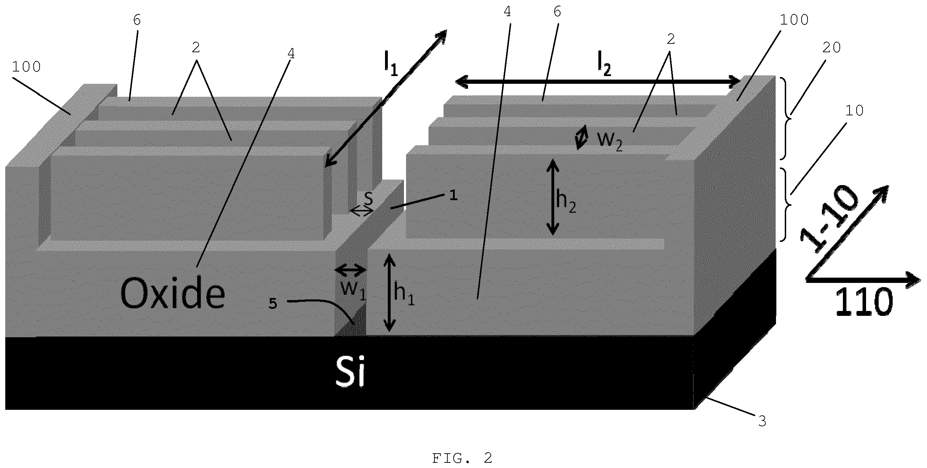

In order to trap the defects in all directions, including the direction along the trenches wherein the state of the art gives poor results, one embodiment according to the present invention provides a new mask structure illustrated in figure 2, wherein the semiconductor material is grown substantially defect free on a Si-wafer 3 of which the surface is oriented along the (001) crystal plane. The mask structure has a 3-D structure comprising a two-level system of first trenches 1 or vias (holes) on a first level 10 and second trenches 2 on a second level 20. The mask structure is comprising: an array of first (lower) trenches 1, and an array of second (upper) trenches 2 wherein the first trenches are arranged such that the pitch of the first trenches is larger than the length of the second trenches 2 and each of the first trenches exposes at the bottom the substrate 3 (see substrate portion 5 in figure 2), while the bottom of each of the second trenches is at a distance h₁ from the substrate. Preferably and as shown in the embodiment of figure 2, h₁ is equal to the height of the first trenches.

The first level does not necessarily comprise an array of first trenches. In the most general formulation, the first level of the mask may comprise or consist of a dielectric layer 4 (e.g. a Silicon oxide layer), provided with at least one trench 1 through the complete thickness of said layer 4, i.e. exposing a portion 5 of the surface of the substrate 3.

The array of second trenches 2 is much denser than the array of the first trenches 1, having a smaller pitch and preferably oriented orthogonally to the first trenches. This is the case in the embodiment of Figure 2, where the first trenches 1 are oriented along the [1-10] direction and the second trenches along the [110] direction. However deviations from the orthogonal orientation are allowed. A different orientation of the second trenches 2 will result in a different crystalline orientation of the semiconductor material which is laterally filled (grown) in the second trenches, while preserving the defect trapping effect. In different embodiments of the invention, the semiconductor material grown in the second trenches forms the channel of a FinFET device. In conclusion and with reference to figure 2, the second level 20 comprises or consists of a dielectric layer 6 (e.g. silicon oxide), provided with said second trenches 2. The second trenches may or may not reach through the complete thickness of the dielectric layer 6.

First, a central trench 1 (referred also as the 'first trench' or the lower trench' hereinafter) is formed in the oxide deposited on a Si substrate. According to a preferred embodiment, an array of first trenches 1 is actually formed on said substrate, but these first trenches are far removed from each other so that the denser array of the second trenches can be defined in between two adjacent first (central) trenches. For the easier understanding of the concept only one first (central) trench is represented in the figures and described in the different examples. However, it will be understood that the mask structure can be replicated around a plurality of first trenches in an analogue way. This first trench has a length **l₁**, a width **w₁** and height **h₁.** The height **h₁** is at least 3 times the width **w**₁ (**h₁**>=3**w₁**) in order to benefit of the aspect ratio trapping effect during the growth of the relaxed semiconductor in this first trench.

In the oxide mask a second array of trenches 2 perpendicular to the first trench 1 is formed having a length **l₂,** a width **w₂** and a height **h₂.** The height **h₂** is at least least 3 times the width **w₂** (**h₂** >=3**w₂**) in order to benefit of the aspect ratio trapping effect during the growth of the relaxed semiconductor material in the second trenches. The actual values of **l₂**, **w₂**, **h₂** are adapted according to the application. As an example, for FinFET devices at and below 14nm node the following numbers are suitable: **h₂** about 300nm, **w₂** approximately 10nm and **l₂** a few microns.

An embodiment of the mask structure of the invention comprises thus the first trench and the second array of trenches formed in a mask material (i.e. oxide) as shown in Fig 2.

Further the spacing **s** represents the distance between the edge of the first trench and the edge of the arrays of the second trenches as shown in Fig 2. The spacing **s** can vary from 0nm (no spacing) to tens of nm. The distance **(2s+w₁**) determines the pitch along 110 of the arrays of the second trenches.

The method of the invention for producing a semiconductor structure by epitaxial growth of one material on another material with a different lattice constant, using a mask structure as shown in figure 2 is described hereafter, with reference to figures 3a to 3e. The mask structure is placed or produced on a substrate 3 of a first crystalline material, e.g. a Si wafer of (001) orientation. The first trench 1 is first overfilled by the growing layer 11 of the epitaxially grown material, like it is done in the case of standard ART approach, described in Fig. 1. The material of layer 11 is a crystalline material with a different lattice constant than the lattice constant of the substrate. Then 111 facets 12 are formed during the growth, see figure 3a. Defects 13 perpendicular to the trench 1 are trapped whereas defects 14 along the trench remain in the layer.

By continuing the growth, the array of the second trenches 2 will be laterally filled from the 111 planes (as shown in Fig 3b). A second trapping of defects will occur on the first nanometers of the second trenches 2 close to the central (first) trench. At the end of the epitaxial growth step, all the trenches are overfilled as shown in Fig 3c.

After chemical-mechanical polishing (CMP) of the overgrown material, the second trenches 2 are visible again on the surface as shown in Fig 3d. The defective areas (areas where the semiconductor material might still have defects) in and above the central trench can be removed subsequently (e.g. etched by e.g. dry etch using an additional masking step) to obtain finally separated arrays of trenches 2 in which defects are trapped in all directions. Then, defect free relaxed materials are obtained in those trenches, as seen in Fig. 3e.

In the following paragraphs, two alternative fabrication methods for the mask structure of Figure 2 are disclosed:

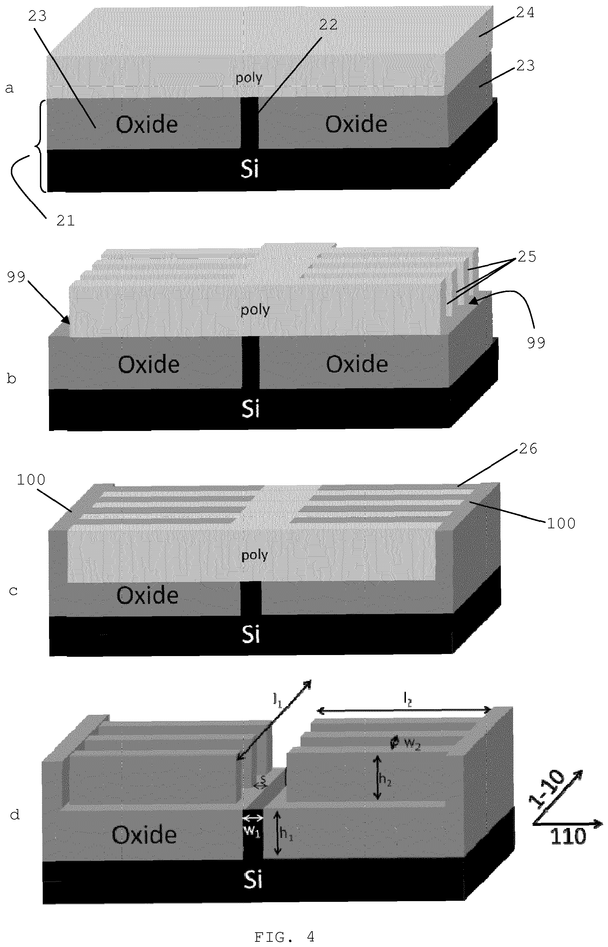

### Fabrication method 1 (Fig. 4a to 4d):

Standard Si STI (Shallow Trench Isolation) wafers 21 are used as starting substrates. A standard Si STI wafer is a Si wafer that has been subjected to a standard STI process : litho+etch to create trenches with Si areas in between the trenches, filling trenches with oxide, CMP for planarizing the surface, resulting in Si-areas 22 separated by oxide areas 23. The standard Si STI wafer suitable as a starting point for fabricating the mask according to the invention thus has first narrow areas 22 defined in the STI oxide to benefit of the aspect ratio trapping effect (preferably **w₁**<**h₁/3**). The pitch of the first areas is larger than the length of the second trenches (**l₂**) which will be processed perpendicularly on top of the STI oxide.

In order to form the array of perpendicular second trenches 2 with a narrow width on top of the STI oxide, a sequential approach can be used wherein trenches are first defined in a sacrificial mask material, as detailed below:
1) a polysilicon (poly Si) layer 24 which acts as a sacrificial mask material is deposited on the Si STI wafer 21 (Fig 4a). A pad oxide (not shown), which can be a thin layer of thermal silicon oxide or CVD oxide, is ideally present between the poly and the Si trenches in order to avoid Si to be attacked during poly etch removal (in step 4).
2) dense trenches 25 with a specific pattern are formed by litho and etching in the poly Si layer (Fig 4b).
3) the trenches 25 defined at step 2) in the poly Si layer are thereafter filled with gap fill silicon oxide 26 and then subjected to CMP (Fig 4c). For patterns having a small pitch the gap fill oxide can be either a high-aspect-ratio-oxide (HARP) oxide, or a reflowable oxide or a high-density plasma (HDP) oxide. A HARP oxide is an oxide film deposited using an ozone/tetraethyl-orthosilicate (O₃/TEOS)-based sub-atmospheric chemical vapour deposition (SACVD) process.
4) poly Si lines are removed (Fig. 4d) selectively to the oxide fill, thereby forming the array of the second trenches 2, perpendicular on the first (central) Si area 22
5) Before growing epitaxially the semiconductor materials, Si is recessed in-situ in the area 22 by e.g. HCl vapor, preferably in the same epitaxial reactor where the growth takes place.

Alternatively, instead of the STI substrates and the polysilicon sacrificial mask of the above example, a dielectric stack comprising two dielectric layers can be formed on a blanket substrate. The dielectric stack can comprise two dielectric materials with different removal (dry etch) rates but the same compatibility towards the epi growth of the semiconductor material in contact with the dielectrics. In other embodiments the dielectric stack can comprise two layers of the same dielectric material.

The first trenches 1 and the second trenches 2 are patterned in the dielectric stack to form finally a structure as shown in Figure 4d. Optionally, an etch-stop layer may be used in between the two dielectric layers to control the patterning process. This etch-stop layer should be made of a material which is compatible with the epitaxial growth of the semiconductor material such that no defects are introduced. Alternatively a timed-etch removal can be used to control the etch process of the second and the first array of trenches. Advantageously, the deposited and patterned dielectric or dielectric stack can be optimized towards better integration and/or fin height control without having to comply with the requirement of good gap fill.

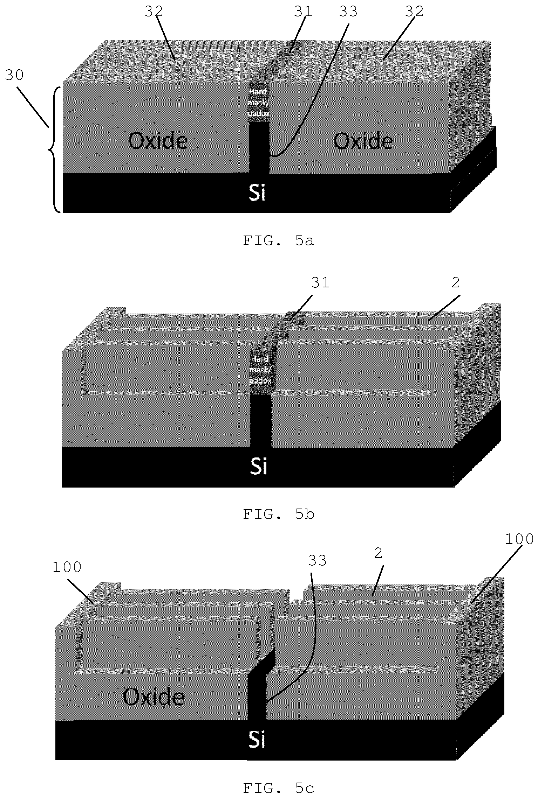

### Fabrication method 2 (Fig. 5a-b-c):

1) In this fabrication technique the initial substrates are Si STI wafers 30 wherein the STI fabrication process is not fully completed. More specifically the initial substrates are used before the nitride hardmask removal in STI fabrication. At this stage in fabrication the stack comprising the silicon nitride hardmask and padoxide 31 separating the STI oxide regions 32 is still present on the wafer on top of the Si area 33 as represented in Fig 5a.
2) Next, the array of second trenches 2 is formed in the STI-oxide by patterning (litho and etch) selectively to the nitride hardmask as shown in Fig 5b. For the patterning of the array of second trenches a soft hardmask (not shown) made of e.g. amorphous carbon material such as APF™ can be used.
3) Then, the nitride hardmask 31 used in the Si-STI process is removed as shown in Fig .
4) (not shown) The Si area 33 is removed, thereby forming the first central trench 1 perpendicular on the array of second trenches already formed. Possibly this area 33 is recessed in-situ by e.g. HCl vapor, preferably in the same epitaxial reactor where the growth takes place.

Particular embodiments of the invention describe alternative mask structures suitable to be used with the method of the invention.

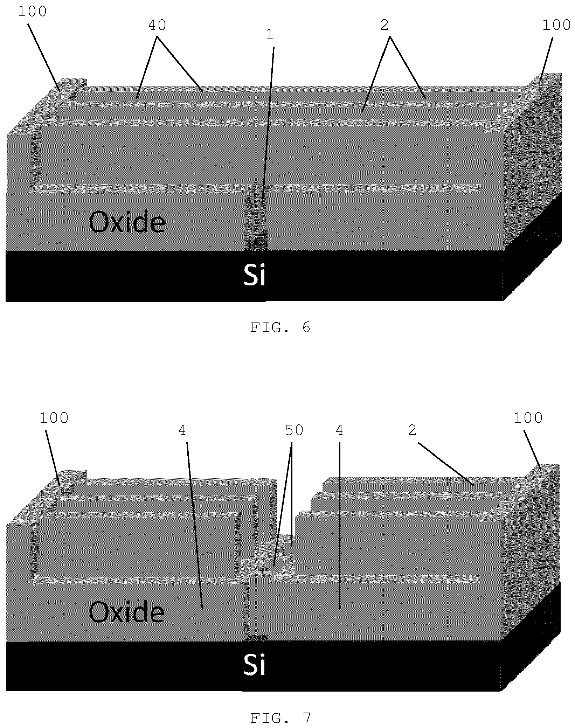

Fig 6 shows a mask structure according to an embodiment of the invention having continuous lines 40 (un-interrupted lines) of a dielectric material defining an array of un-interrupted (continuous) second trenches 2 on top of the STI oxide instead of 2 separate arrays of second trenches on both sides of the central trench as in Fig 2.

Fig 7 shows a mask structure according to another embodiment of the invention having the single narrow trench 1 (the first trench) of the embodiment of Figure 2 replaced by a row of holes/vias 50, generally referred to as 'openings' so that the initial growth of the semiconductor material takes place in said openings instead of the single narrow trench. Like the trench 1 in figure 2, the openings 50 are made through the complete thickness of the dielectric layer of 4 the mask's first level. The vias may have a polygonal or a substantially circular cross-section. The array of the second trenches 2 is similar with the one described in connection with Fig. 2, i.e. the second trenches are at an angle different from zero (perpendicular in the case of figure 7) with respect to the row of openings 50.

The method of the invention is suitable for forming high quality epitaxially grown semiconductor materials in narrow trenches which can be used for forming e.g. FinFET devices or photonic devices. The semiconductor materials are either group IV semiconductor materials or alloys such as Si, Ge and SiGe or group III-V compounds such as binary or tertiary III-V compounds. Non limiting examples of III-V compounds may comprise GaAs, InP, InGaAs, InSb and any combinations or mixtures thereof.

The mask structure can be formed as a layer or a multi-layer in a dielectric material such as silicon oxide or silicon nitride or combinations and mixtures thereof.

The method as described above and illustrated in figures 3a to 3e for producing a defect-free structure by epitaxial growth is summarized hereafter as comprising the steps of :
- Providing a substrate 3 formed of a first crystalline material, e.g. a Si substrate 3 as shown in figure 3a,
- Placing or producing a mask structure on the surface of said substrate, the mask structure comprising :
   ∘ A first level 10 comprising a first dielectric layer 4 provided with at least one trench 1, said trench being made through the complete thickness of said layer 4, so that the bottom of said trench is formed by a portion 5 of the surface of said substrate,
   ∘ A second level 20 on top of the first level, the second level comprising a second dielectric layer 6, said second layer 6 being provided with one or more trenches 2 oriented at an angle different from zero with respect to said first trench 1, at least a portion of the second trench or trenches being located laterally with respect to the longitudinal direction of said first trench,
- Growing a second crystalline material by epitaxial growth on said surface portion (5), the second material having a lattice constant that is different from the lattice constant of the first material, said second material overgrowing said first trench (1) and forming a layer (11) of the second material, wherein :
   ∘ the depth and width of said first trench (1) or the depth and cross-section of the openings (50) in said row of openings is such that lattice defects (13) propagating in the longitudinal direction of said second trench (2) are trapped in said first trench (1) or in said openings (50),
   ∘ the depth and width of the second trench or trenches (2) is such that essentially defect-free material grows in at least a portion of the second trench or trenches (2).
- Stopping said growing step when said layer (11) overfills all of the second trenches (2),
- planarizing the layer (11) of the second material.

In the above-described description of the method of the invention, the first trench may be replaced by a row of openings 50, with reference to the embodiment of figure 7.

The invention is equally related to the mask structure as such, as described in the two preceding paragraphs.

In the embodiments shown in Figures 2 to 7, the mask structure comprises barrier walls 100 on opposite sides of the first trench 1 (fig. 2-6) or the row of openings (fig. 7). The function of these barriers is to inhibit further expansion of the epitaxial growth in the horizontal direction beyond the barrier, as illustrated in figure 3c. When the first trench 1 is part of an array of trenches, the barrier 100 ensures that the epitaxially growing layers 11 originating from two neighbouring trenches 1 do not merge, which would generate further undesirable defects. In the production method for producing the mask structure illustrated in figures 4a to 4d, the barrier 100 is taken into account in the patterning of the poly-mask. To do this, poly is patterned by removing the poly not only in trenches 25 perpendicular to the first trench 1, but also in lateral areas 99 on opposite sides of the first trench. The barrier 100 may be present on all four sides of the mask, instead of only on the two opposite sides on either side of the first trench 1. As shown in figure 3e, the barriers 100 may be removed after the CMP step, together with the removal of the defective areas in and above the first trench 1.

Even without using the barriers 100, the above-described embodiments provide a method and a mask structure for obtaining defect free fin-shaped structures in at least a portion of the material that is epitaxially grown in the trenches on the second level of the mask. If merging of two neighbouring layers occurs in the absence of the barriers, the merged area may be removed at the end of the method (analogue to removal of the barrier in figure 5b).

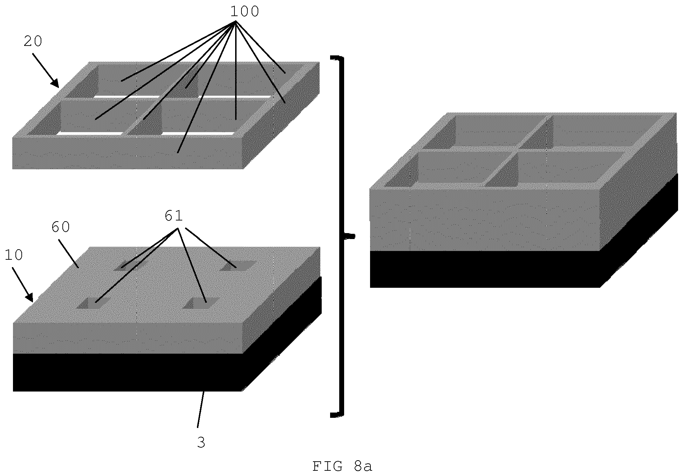

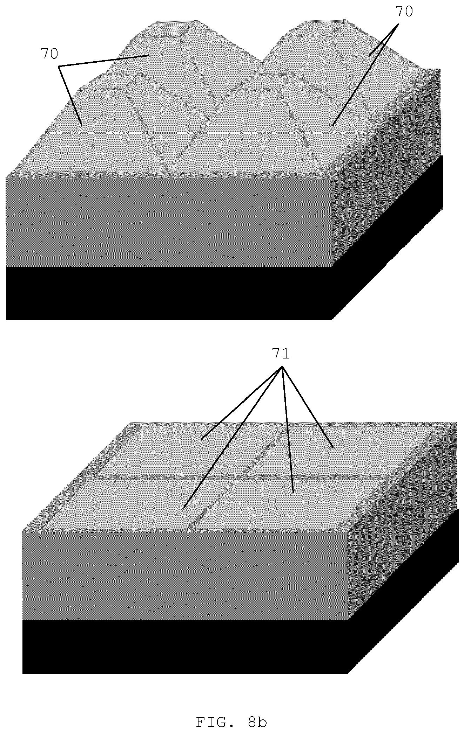

Another aspect of the disclosure not part of the invention is illustrated in figures 8a and 8b. According to this aspect, the invention is related to a method for epitaxially growing a structure as described above, but wherein the mask comprises two levels with the second level consisting only of one or several sets of barriers. In the embodiment of figure 8a, the first level 10 comprises a dielectric layer 60 (e.g. Si-oxide) provided with an array of regularly spaced holes 61 through the complete thickness of the layer 60. The second level 20 comprises a framework of barriers 100, so that a square-shaped barrier is placed concentrically around each of the holes 61. This mask is placed or produced on top of a substrate 3 of a first crystalline material (e.g. a silicon wafer). The mask may be produced by one of the above-described methods for producing the mask structure of figure 2, for example by appropriately changing the patterning of the poly layer 24 in the method of figures 4a to 4d.

Figure 8b illustrates the epitaxial deposition and growth of a second crystalline material 70 that is lattice-mismatched with the first crystalline material of the substrate 3. The depth and cross-section of the holes 61 is such that essentially all defects propagating from the substrate surface 5 (not visible) at the bottom of the holes 61 are trapped in said holes, so that all the material that grows over the edge of the holes is essentially defect-free. The barriers 100 ensure that no additional defects are generated by the merger of epitaxial material grown from neighbouring holes 61. The growing step is stopped when the epitaxial layer covers at least a portion of the height of the barriers 101. Preferably the growth continues until the layers reach or overgrow the complete height of the barrier, as shown in figure 8b. This is followed by a CMP step, removing all the material above the height of the barriers 100, resulting in 2-dimensional areas 71 of defect free epitaxially grown material, suitable for example for being used as active areas in semiconductor devices.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A method for producing an essentially defect-free epitaxially grown structure, comprising the steps of :
- providing a substrate (3) formed of a first crystalline material,
- placing or producing a mask structure on the surface of said substrate, the mask structure comprising:
• a first level (10) comprising a first dielectric layer (4,60) provided with at least one opening (1,50,61) through the complete thickness of said layer, so that the bottom of said opening is formed by a portion (5) of the surface of said substrate (3),
• a second level (20) on top of the first, the second level comprising one or more barriers (100) placed at least on two opposite sides of each of said at least one opening (1,61) or of a group of said openings (50),
- growing a second crystalline material by epitaxial growth on said surface portion (5), the second material having a lattice constant that is different from the lattice constant of the first material, said second material overgrowing said opening (1,61,50) and forming a layer (11) of the second material, wherein the depth and shape of said opening (1,61,50) is such that lattice defects propagating from said surface portion (5) in at least one direction are trapped in said opening (1,61,50), by having a depth of said opening being equal to or higher than three times its width,
- stopping said growing step when at least a part of the height of said barrier (100) is covered by the layer (11) of the second material,
- planarizing the layer (11) of the second material,
wherein :
- said opening is a first trench (1) provided in the first dielectric layer (4) OR the first dielectric layer (4) comprises a row of said openings (50),
- the second level further comprises a second dielectric layer (6) on the first dielectric layer (4,60) provided with at least one second trench (2) oriented at an angle different from zero with respect to the first trench (1) or with respect to said row of openings (61), at least a portion of the second trench or trenches (2) being located laterally with respect to the longitudinal direction of said first trench (1) or row of openings (50),
- any defects propagating in the longitudinal direction of said second trench(es) (2) are trapped in said first trench (1) or in said row of openings (50),
- the depth and width of the second trench or trenches (2) is such that essentially defect-free material grows in at least a portion of the second trench or trenches (2), by having a depth of said second trench(es) (2) being equal to or higher than three times its width,
- said barriers (100) are located at least on two opposite sides of the longitudinal direction of said first trench (1) or of said row of openings (50).

2. Method according to claim 1, wherein the second level (20) comprises one or more arrays of mutually parallel trenches (2), each array being located laterally with respect to the longitudinal direction of said first trench or row of openings.

3. Method according to claim 1 or 2, wherein the second trench (2) is oriented perpendicularly to the first trench (1) or the row of openings (50).

4. Method according to any one of claims 1 to 3, further comprising the step of removing at least the epitaxially grown material in said first trench (1) or row of openings (50) and directly above said first trench or openings, so that at least portions of said second trench(es) remain which consist of essentially defect-free material.

5. Method according to any one of claims 1 to 4, wherein the first and second materials are semiconductor materials.

6. Method according to any of the previous claims, whereby after planarising the layer (11) of the second material, the trenches (2) are again visible.

7. Mask structure for epitaxially growing a second crystalline material on a surface portion (5) of a substrate (3) formed of a first crystalline material, and suitable for carrying out the method of claim 1, said materials having different lattice constants, when the mask structure is present on said substrate, said mask structure comprising :
- a first level (10) comprising a first dielectric layer (4,60) provided with at least one opening (1,50,61) through the complete thickness of said layer, so that the bottom of said opening is formed by a portion (5) of the surface of said substrate (3),
- a second level (20) on top of the first, the second level comprising one or more barriers (100) placed at least on two opposite sides of each of said openings (1,61) or of a group of said openings (50),
wherein :
- said opening is a first trench (1) provided in the first dielectric layer (4) OR the first dielectric layer (4) comprises a row of said openings (50), said opening(s) having a depth being equal to or higher than three times its width;
- the second level further comprises a second dielectric layer (6) on the first dielectric layer (4,60) provided with at least one second trench (2) oriented at an angle different from zero with respect to the first trench (1) or with respect to said row of openings (61), at least a portion of the second trench or trenches being (2) located laterally with respect to the longitudinal direction of said first trench (1) or row of openings (50), wherein the depth of the second trench is equal to or higher than three times its width,
- said barriers (100) are located at least on two opposite sides of the longitudinal direction of said first trench (1) or of said row of openings (50).

8. Mask structure according to claim 7, wherein the second level (20) comprises one or more arrays of mutually parallel trenches (2), each array being located laterally with respect to the longitudinal direction of said first trench or row of openings.

9. Mask structure according to claim 7 or 8, wherein the second trench (2) is oriented perpendicularly to the first trench (1) or the row of openings (50).

## Patentansprüche

1. Verfahren zum Herstellen einer im Wesentlichen defektfreien, epitaktisch aufgewachsenen Struktur, umfassend die Schritte des:
- Bereitstellens eines Substrats (3), das aus einem ersten kristallinen Material gebildet ist,
- Platzierens oder Herstellens einer Maskenstruktur auf der Oberfläche des Substrats, wobei die Maskenstruktur umfasst:
• eine erste Ebene (10), die eine erste dielektrische Schicht (4, 60) umfasst, welche mit mindestens einer Öffnung (1, 50, 61) durch die komplette Dicke der Schicht hindurch versehen ist, sodass der Boden der Öffnung von einem Abschnitt (5) der Oberfläche des Substrats (3) gebildet wird,
• eine zweite Ebene (20) oberhalb der ersten, wobei die zweite Ebene eine oder mehrere Barrieren (100) umfasst, die mindestens auf zwei gegenüberliegenden Seiten jeder der mindestens einen Öffnung (1, 61) oder einer Gruppe der Öffnungen (50) platziert sind,
- Aufwachsens eines zweiten kristallinen Materials durch epitaktisches Wachstum auf dem Oberflächenabschnitt (5), wobei das zweite Material eine Gitterkonstante aufweist, die sich von der Gitterkonstante des ersten Materials unterscheidet, wobei das zweite Material die Öffnung (1, 61, 50) überwächst und eine Schicht (11) des zweiten Materials bildet, wobei die Tiefe und Form der Öffnung (1, 61, 50) derart ist, dass Gitterdefekte, die sich vom Oberflächenabschnitt (5) in mindestens eine Richtung ausbreiten, in der Öffnung (1, 61, 50) gefangen werden, indem dieselbe eine Tiefe der Öffnung aufweist, welche gleich oder mehr als das Dreifache ihrer Breite beträgt,
- Stoppens des Aufwachsschrittes, wenn mindestens ein Teil der Höhe der Barriere (100) von der Schicht (11) des zweiten Materials bedeckt ist,
- Einebnens der Schicht (11) des zweiten Materials,
wobei:
- die Öffnung ein erster Graben (1) ist, der in der ersten dielektrischen Schicht (4) bereitgestellt ist, ODER die erste dielektrische Schicht (4) eine Reihe der Öffnungen (50) umfasst,
- die zweite Ebene weiter eine zweite dielektrische Schicht (6) auf der ersten dielektrischen Schicht (4, 60) umfasst, die mit mindestens einem zweiten Graben (2) versehen ist, der in Bezug auf den ersten Graben (1) oder in Bezug auf die Reihe von Öffnungen (61) in einem Winkel von ungleich Null ausgerichtet ist, wobei mindestens ein Abschnitt des zweiten Grabens oder der Gräben (2) in Bezug auf die Längsrichtung des ersten Grabens (1) oder der Reihe von Öffnungen (50) seitlich liegt,
- jegliche Defekte, die sich in der Längsrichtung des/der zweiten Grabens/Gräben (2) ausbreiten, im ersten Graben (1) oder in der Reihe von Öffnungen (50) gefangen werden,
- die Tiefe und Breite des/der zweiten Grabens oder Gräben (2) derart ist, dass im Wesentlichen defektfreies Material in mindestens einem Abschnitt des/der zweiten Grabens oder Gräben (2) aufwächst, indem der-/dieselbe(n) eine Tiefe des/der zweiten Grabens/Gräben (2) aufweist/aufweisen, die gleich oder mehr als das Dreifache seiner/ihrer Breite beträgt,
- die Barrieren (100) mindestens auf zwei gegenüberliegenden Seiten der Längsrichtung des ersten Grabens (1) oder der Reihe von Öffnungen (50) liegen.

2. Verfahren nach Anspruch 1, wobei die zweite Ebene (20) eine oder mehrere Anordnungen von zueinander parallelen Gräben (2) umfasst, wobei jede Anordnung in Bezug auf die Längsrichtung des ersten Grabens oder der Reihe von Öffnungen seitlich liegt.

3. Verfahren nach Anspruch 1 oder 2, wobei der zweite Graben (2) senkrecht zum ersten Graben (1) oder der Reihe von Öffnungen (50) ausgerichtet ist.

4. Verfahren nach einem der Ansprüche 1 bis 3, weiter den Schritt des Entfernens von mindestens dem epitaktisch aufgewachsenen Material im ersten Graben (1) oder der Reihe von Öffnungen (50) und unmittelbar über dem ersten Graben oder den Öffnungen umfassend, sodass mindestens Abschnitte des/der zweiten Grabens/Gräben verbleiben, die aus im Wesentlichen defektfreien Material bestehen.

5. Verfahren nach einem der Ansprüche 1 bis 4, wobei das erste und zweite Material Halbleitermaterialien sind.

6. Verfahren nach einem der vorstehenden Ansprüche, wobei nach dem Einebnen der Schicht (11) des zweiten Materials die Gräben (2) erneut sichtbar sind.

7. Maskenstruktur zum epitaktischen Aufwachsen eines zweiten kristallinen Materials auf einem Oberflächenabschnitt (5) eines Substrats (3), das aus einem ersten kristallinen Material gebildet ist, und dafür geeignet ist, das Verfahren nach Anspruch 1 auszuführen, wobei die Materialien unterschiedliche Gitterkonstanten aufweisen, wenn die Maskenstruktur auf dem Substrat vorhanden ist, wobei die Maskenstruktur umfasst:
- eine erste Ebene (10), die eine erste dielektrische Schicht (4, 60) umfasst, welche mit mindestens einer Öffnung (1, 50, 61) durch die komplette Dicke der Schicht hindurch versehen ist, sodass der Boden der Öffnung von einem Abschnitt (5) der Oberfläche des Substrats (3) gebildet wird,
- eine zweite Ebene (20) oberhalb der ersten, wobei die zweite Ebene eine oder mehrere Barrieren (100) umfasst, die mindestens auf zwei gegenüberliegenden Seiten jeder der Öffnungen (1, 61) oder einer Gruppe der Öffnungen (50) platziert sind,
wobei:
- die Öffnung ein erster Graben (1) ist, der in der ersten dielektrischen Schicht (4) bereitgestellt ist, ODER die erste dielektrische Schicht (4) eine Reihe der Öffnungen (50) umfasst, wobei die Öffnung(en) eine Tiefe aufweisen, die gleich oder mehr als das Dreifache ihrer Breite beträgt;
- die zweite Ebene weiter eine zweite dielektrische Schicht (6) auf der ersten dielektrischen Schicht (4, 60) umfasst, die mit mindestens einem zweiten Graben (2) versehen ist, der in Bezug auf den ersten Graben (1) oder in Bezug auf die Reihe von Öffnungen (61) in einem Winkel von ungleich Null ausgerichtet ist, wobei mindestens ein Abschnitt des zweiten Grabens oder der Gräben (2) in Bezug auf die Längsrichtung des ersten Grabens (1) oder der Reihe von Öffnungen (50) seitlich liegt, wobei die Tiefe des zweiten Grabens gleich oder mehr als das Dreifache seiner Breite beträgt,
- die Barrieren (100) mindestens auf zwei gegenüberliegenden Seiten der Längsrichtung des ersten Grabens (1) oder der Reihe von Öffnungen (50) liegen.

8. Maskenstruktur nach Anspruch 7, wobei die zweite Ebene (20) eine oder mehrere Anordnungen aus zueinander parallelen Gräben (2) umfasst, wobei jede Anordnung in Bezug auf die Längsrichtung des ersten Grabens oder der Reihe von Öffnungen seitlich liegt.

9. Maskenstruktur nach Anspruch 7 oder 8, wobei der zweite Graben (2) senkrecht zum ersten Graben (1) oder der Reihe von Öffnungen (50) ausgerichtet ist.

## Revendications

1. Procédé de production d'une structure pratiquement sans défaut obtenue par croissance épitaxiale, comprenant les étapes suivantes :
- fourniture d'un substrat (3) formé d'un premier matériau cristallin,
- mise en place ou production d'une structure de masque sur la surface dudit substrat, la structure de masque comprenant :
• un premier niveau (10) comprenant une première couche diélectrique (4, 60) pourvue d'au moins une ouverture (1, 50, 61) dans l'épaisseur complète de ladite couche, de sorte que le fond de ladite ouverture est formé par une partie (5) de la surface dudit substrat (3),
• un second niveau (20) sur le premier, le second niveau comprenant une ou plusieurs barrières (100) placées au moins sur deux côtés opposés de chacune de ladite au moins une ouverture (1, 61) ou d'un groupe desdites ouvertures (50),
- croissance d'un second matériau cristallin par croissance épitaxiale sur ladite partie de surface (5), le second matériau ayant une constante de réseau qui est différente de la constante de réseau du premier matériau, ledit second matériau recouvrant ladite ouverture (1, 61, 50) et formant une couche (11) du second matériau, dans lequel la profondeur et la forme de ladite ouverture (1, 61, 50) sont telles que des défauts de réseau se propageant depuis ladite partie de surface (5) dans au moins une direction sont emprisonnés dans ladite ouverture (1, 61, 50), la profondeur de ladite ouverture étant supérieure ou égale à trois fois sa largeur,
- arrêt de ladite étape de croissance lorsqu'au moins une partie de la hauteur de ladite barrière (100) est recouverte par la couche (11) du second matériau,
- aplanissement de la couche (11) du second matériau,
dans lequel :
- ladite ouverture est une première tranchée (1) fournie dans la première couche diélectrique (4) OU la première couche diélectrique (4) comprend une rangée desdites ouvertures (50),
- le second niveau comprend en outre une seconde couche diélectrique (6) sur la première couche diélectrique (4, 60) pourvue d'au moins une seconde tranchée (2) orientée selon un angle différent de zéro par rapport à la première tranchée (1) ou par rapport à ladite rangée d'ouvertures (61), au moins une partie de la seconde ou des secondes tranchées (2) étant située latéralement par rapport à la direction longitudinale desdites première tranchée (1) ou rangée d'ouvertures (50),
- d'éventuels défauts se propageant dans la direction longitudinale de ladite ou desdites secondes tranchées (2) sont emprisonnés dans ladite première tranchée (1) ou dans ladite rangée d'ouvertures (50),
- la profondeur et la largeur de la seconde ou des secondes tranchées (2) sont telles qu'un matériau pratiquement sans défaut croît dans au moins une partie de la seconde ou des secondes tranchées (2), la profondeur de ladite ou desdites secondes tranchées (2) étant supérieure ou égale à trois fois leur largeur,
- lesdites barrières (100) sont situées au moins sur deux côtés opposés de la direction longitudinale de ladite première tranchée (1) ou de ladite rangée d'ouvertures (50).

2. Procédé selon la revendication 1, dans lequel le second niveau (20) comprend un ou plusieurs réseaux de tranchées (2) parallèles entre elles, chaque réseau étant situé latéralement par rapport à la direction longitudinale de ladite première tranchée ou rangée d'ouvertures.

3. Procédé selon les revendications 1 ou 2, dans lequel la seconde tranchée (2) est orientée perpendiculairement à la première tranchée (1) ou à la rangée d'ouvertures (50).

4. Procédé selon l'une quelconque des revendications 1 à 3, comprenant en outre l'étape de retrait au moins du matériau obtenu par croissance épitaxiale dans ladite première tranchée (1) ou rangée d'ouvertures (50) et directement au-dessus de ladite première tranchée ou desdites ouvertures, de sorte qu'il reste au moins certaines parties de la seconde ou des secondes tranchées qui sont constituées d'un matériau pratiquement sans défaut.

5. Procédé selon l'une quelconque des revendications 1 à 4, dans lequel les premier et second matériaux sont des matériaux semi-conducteurs.

6. Procédé selon l'une quelconque des revendications précédentes, moyennant quoi après aplanissement de la couche (11) du second matériau, les tranchées (2) sont à nouveau visibles.

7. Structure de masque destinée à la croissance épitaxiale d'un second matériau cristallin sur une partie de surface (5) d'un substrat (3) formé d'un premier matériau cristallin et adaptée à la réalisation du procédé selon la revendication 1, lesdits matériaux ayant des constantes de réseau différentes, lorsque la structure de masque se trouve sur ledit substrat, ladite structure de masque comprenant :
• un premier niveau (10) comprenant une première couche diélectrique (4, 60) pourvue d'au moins une ouverture (1, 50, 61) dans l'épaisseur complète de ladite couche, de sorte que le fond de ladite ouverture est formé par une partie (5) de la surface dudit substrat (3),
• un second niveau (20) sur le premier, le second niveau comprenant une ou plusieurs barrières (100) placées au moins sur deux côtés opposés de chacune desdites ouvertures (1, 61) ou d'un groupe desdites ouvertures (50),
dans laquelle :
- ladite ouverture est une première tranchée (1) fournie dans la première couche diélectrique (4) OU la première couche diélectrique (4) comprend une rangée desdites ouvertures (50), ladite ou lesdites ouvertures ayant une profondeur supérieure ou égale à trois fois leur largeur ;
- le second niveau comprend en outre une seconde couche diélectrique (6) sur la première couche diélectrique (4, 60) pourvue d'au moins une seconde tranchée (2) orientée selon un angle différent de zéro par rapport à la première tranchée (1) ou par rapport à ladite rangée d'ouvertures (61), au moins une partie de la seconde ou des secondes tranchées (2) étant située latéralement par rapport à la direction longitudinale desdites première tranchée (1) ou rangée d'ouvertures (50), dans laquelle la profondeur de la seconde tranchée est supérieure ou égale à trois fois sa largeur,
- lesdites barrières (100) sont situées au moins sur deux côtés opposés de la direction longitudinale de ladite première tranchée (1) ou de ladite rangée d'ouvertures (50).

8. Structure de masque selon la revendication 7, dans laquelle le second niveau (20) comprend un ou plusieurs réseaux de tranchées (2) parallèles entre elles, chaque réseau étant situé latéralement par rapport à la direction longitudinale de ladite première tranchée ou rangée d'ouvertures.

9. Structure de masque selon les revendications 7 ou 8, dans laquelle la seconde tranchée (2) est orientée perpendiculairement à la première tranchée (1) ou à la rangée d'ouvertures (50).
